(19) Europäisches Patentamt
European Patent Office
Office européen des brevets

(11) EP 4 447 238 A1

(12) **EUROPEAN PATENT APPLICATION**
published in accordance with Art. 153(4) EPC

(43) Date of publication:
**16.10.2024 Bulletin 2024/42**

(21) Application number: **22904276.7**

(22) Date of filing: **07.12.2022**

(51) International Patent Classification (IPC):
***H01S 5/50*** (2006.01) ***G02F 1/35*** (2006.01)
***H01S 3/0933*** (2006.01) ***H01S 5/042*** (2006.01)

(52) Cooperative Patent Classification (CPC):
**G02F 1/35; H01S 3/0933; H01S 5/042; H01S 5/50**

(86) International application number:
**PCT/JP2022/045183**

(87) International publication number:
**WO 2023/106348 (15.06.2023 Gazette 2023/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **08.12.2021 JP 2021199119**

(71) Applicant: **Furukawa Electric Co., Ltd.**
**Tokyo 100-8322 (JP)**

(72) Inventors:
- **OGOSHI, Haruki**
  **Tokyo 100-8322 (JP)**
- **YOSHIDA, Junji**
  **Tokyo 100-8322 (JP)**
- **INABA, Yusuke**
  **Ichihara-shi, Chiba 290-8555 (JP)**
- **KIMOTO, Tatsuya**
  **Tokyo 100-8322 (JP)**
- **FUNABASHI, Masaki**
  **Tokyo 100-8322 (JP)**
- **ICHINO, Seiji**
  **Tokyo 100-8322 (JP)**
- **HOJO, Naoya**
  **Ichihara-shi, Chiba 290-8555 (JP)**
- **TAKASAKA, Shigehiro**
  **Tokyo 100-8322 (JP)**
- **SUGIZAKI, Ryuichi**
  **Tokyo 100-8322 (JP)**
- **THUDSALINGKARNSAKUL, Nitidet**
  **Phranakorn Sri Ayutthaya 13210 (TH)**
- **ANANTATHANASARN, Sanguan**
  **Phranakorn Sri Ayutthaya 13210 (TH)**

(74) Representative: **SSM Sandmair**
**Patentanwälte Rechtsanwalt**
**Partnerschaft mbB**
**Joseph-Wild-Straße 20**
**81829 München (DE)**

(54) **LIGHT SOURCE, LIGHT SOURCE DEVICE, DRIVE METHOD FOR LIGHT SOURCE, RAMAN AMPLIFIER, AND RAMAN AMPLIFICATION SYSTEM**

(57) A light source includes a seed light source and a booster amplifier. The seed light source outputs incoherent seed light having a predetermined bandwidth. The booster amplifier serves as a semiconductor optical amplifier that optically amplifies the seed light entered through a first end facet and outputs the amplified light through a second end facet. The booster amplifier has nL being set, which is the product of a refractive index n and a chip length L, so that relative intensity noise (RIN) and ripple are simultaneously suppressed in the amplified light.

FIG.1

100
10
11
L1
12
13
L2
14
15
C1
C2
101
102

EP 4 447 238 A1

## Description

Field

The present invention relates to a light source, a light source device, a method of driving the light source, a Raman amplifier, and a Raman amplification system.

Background

In the field of optical fiber communication, so far, the use of Erbium-doped fiber amplifiers (EDFAs) has enabled the expansion of transmission distance and capacity. However, at present, it has become an indispensable technology to utilize not only EDFA but also Raman amplification and to effectively combine the two. Currently, the predominant technique of Raman amplification is backward-pumped Raman amplification where pumping light is incident on an optical fiber for Raman amplification to propagate in a direction opposite to the propagation direction of signal light. However, for further advancements towards next-generation requirements such as increased speed (800 Gb/s), longer transmission distances (1000 km), and wider bandwidth (utilization of L and S-band), it is crucial to use a technique called forward-pumped Raman amplification in which pumping light is incident on the optical fiber for Raman amplification so that it propagates in the same direction as the signal light propagation direction, at the same time as backward-pumped Raman amplification. This technique is called bidirectional-pumped Raman amplification. Moreover, it has been reported that the flatness and bandwidth enhancement of a Raman gain can be achieved with backward-pumped Raman amplification alone by using wavelength-multiplexed pumping, but noise figure (NF) flattening fails to be achieved without using bidirectional-pumped Raman amplification (Non-patent Literatures 13 and 14).

In forward pumping, a pumping light source with low relative intensity noise (RIN) is required. The reason for this is as follows. RIN is an index that normalizes minute intensity fluctuation components of laser light with the total optical power. The phenomenon of Raman amplification occurs because the lifetime of the excited level that produces a gain is short (≈several fsec), so if there is intensity noise in the pumping light source, it becomes noise in the signal light through the amplification process. In EDFA, the lifetime of the excited level is long (≈10 msec), so this concern did not exist. While the gain per unit length in Raman amplification is extremely small compared to EDFA, in forward-pumped Raman amplification, the noise from the pumping light gradually transfers as noise of the signal light as the signal light and the pumping light propagate together over long distances in the optical fiber. This is called RIN transfer. In backward-pumped Raman amplification, the signal light and pumping light are counter-propagating, so the time for the pumping light with a certain noise component and the signal light to intersect is short, resulting in the minimal influence of the noise of the pumping light on the signal light. Additionally, since the noise of the pumping light is random, even if the signal light is affected, it is gradually averaged out as it progresses in the opposite direction. As can be seen from the above, in forward-pumped Raman amplification, the characteristics of low RIN transfer are required, particularly, in dispersion-shifted fibers (DSF) or non-zero dispersion-shifted fibers (NZDSF) where the group velocity difference between the signal light and the pumping light is small, and the time for parallel transmission within the optical fiber is long, reduction of this RIN transfer is important (Non-patent Literatures 1, 3, and 4). For example, NZDSF is an optical fiber conforming to the International Telecommunications Union (ITU) ITU-T G. 655 standard.

Citation List

Patent Literature

Patent Literature 1: US Patent Publication No. 2014/0153083
Patent Literature 2: US Patent No. 07190861
Patent Literature 3: US Patent No. 07215836
Patent Literature 4: US Patent No. 07236295
Patent Literature 5: US Patent No. 07173757
Patent Literature 6: JP Patent No. 4069110
Patent Literature 7: US Patent No. 10938175


Non Patent Literature

Non Patent Literature 1: PELOUCH, Wayne S. Raman amplification: An enabling technology for long-haul coherent transmission systems. Journal of Lightwave Technology, 2015, 34.1: 6-19.
Non Patent Literature 2: YAMAMOTO, Y.; MACHIDA, S.; NILSSON, O. Amplitude squeezing in a pump-noise-suppressed laser oscillator. Physical Review A, 1986, 34.5: 4025.
Non Patent Literature 3: KEITA, Kafing, et al. Relative intensity noise transfer of large-bandwidth pump lasers in Raman fiber amplifiers. JOSA B, 2006, 23.12: 2479-2485.
Non Patent Literature 4: FLUDGER, C. R. S.; HANDEREK, V.; MEARS, R. J. Pump to signal RIN transfer in Raman fiber amplifiers. Journal of Lightwave Technology, 2001, 19.8: 1140.
Non Patent Literature 5: VAKHSHOORI, D., et al. Raman amplification using high-power incoherent semiconductor pump sources. In: Optical Fiber Communication Conference. Optical Society of America, 2003. p. PD47.
Non Patent Literature 6: YAMATOYA, T.; KOYAMA, F.; IGA, K. Noise suppression and intensity modulation using gain-saturated semiconductor optical amplifier. In: Optical Amplifiers and Their Applications. Optical Society of America, 2000. p. OMD12.
Non Patent Literature 7: KOYAMA, F. High power superluminescent diodes for multi-wavelength light sources. In: Conference Proceedings. LEOS'97. 10th Annual Meeting IEEE Lasers and Electro-Optics Society 1997 Annual Meeting. IEEE, 1997. p. 333-334.
Non Patent Literature 8: ZHAO, Mingshan; MORTHIER, Geert; BAETS, Roel. Analysis and optimization of intensity noise reduction in spectrum-sliced WDM systems using a saturated semiconductor optical amplifier. IEEE Photonics Technology Letters, 2002, 14.3: 390-392.
Non Patent Literature 9: MORIMOTO, Masahito, et al. Co-propagating dual-order distributed Raman amplifier utilizing incoherent pumping. IEEE Photonics Technology Letters, 2017, 29.7: 567-570.
Non Patent Literature 10: MORIMOTO, Masahito, et al. Co-propagating distributed Raman amplifier utilizing incoherent pumping. In: Metro and Data Center Optical Networks and Short-Reach Links II. International Society for Optics and Photonics, 2019. p. 109460M.
Non Patent Literature 11: KOBAYASHI, Takayuki, et al. 2nd-order forward-pumped distributed Raman amplification employing SOA-based incoherent light source in PDM-16QAM WDM transmission system. IEICE Communications Express, 2019.
Non Patent Literature 12: KOBAYASHI, Takayuki, et al. PDM-16QAM WDM transmission with 2nd-order forward-pumped distributed Raman amplification utilizing incoherent pumping. In: Optical Fiber Communication Conference. Optical Society of America, 2019. p. Tu3F. 6.
Non Patent Literature 13: KADO, Soko, et al. Broadband flat-noise Raman amplifier using low-noise bidirectionally pumping sources. In: Proceedings 27th European Conference on Optical Communication (Cat. No. 01TH8551). IEEE, 2001. p. 38-39.
Non Patent Literature 14: EMORI, Yoshihiro; KADO, Soko; NAMIKI, Shu. Independent control of the gain and noise figure spectra of Raman amplifiers using bidirectional pumping. Furukawa Review, 2003, 23: 11-15.
Non Patent Literature 15: Fiber optic test and measurement/edited by Dennis Derickson. Upper Saddle River, 1998.

## Summary

### Technical Problem

Raman amplification has lower pumping efficiency than optical amplification using EDFA, so a high-power pumping light source is required to achieve sufficient gains. For this reason, Fabry-Perot (FP) type lasers with an output of several hundred mW or more have been widely put into practical use, but FP lasers are considered unsuitable for forward pumping due to significant RIN transfer (Non-Patent Literatures 3, 4, and 5).

On the other hand, to suppress the RIN transfer, it is considered effective to use amplified spontaneous emission (ASE) light from a semiconductor optical amplifier (SOA), which is incoherent light, as a pumping light source for forward-pumped Raman amplification (Patent Literatures 2 and 3, Non-Patent Literatures 3 and 5).

For future ultra-high-speed and high-capacity transmission exceeding 800 Gbps, it is desirable for the Raman gain achieved through forward pumping to be, for example, 7 dB or more, or even 10 dB or more, in order to significantly improve the overall optical signal-to-noise ratio (OSNR) of the system. Thus, for example, a case has been reported where high output was achieved by constructing polarization-multiplexed and wavelength-multiplexed configurations of cascaded-connected SOAs (Non-Patent Literature 5).

While ASE light from a compact and low-cost SOA is certainly a promising candidate, it is known that attempting to achieve high output can result in the occurrence of ripples due to the reflection of light at both end facets of the SOA (Patent Literatures 4, 5, and 6).

According to Non-Patent Literature 3, when using broadband incoherent light for forward-pumped Raman amplification, the RIN transfer is suppressed due to the averaging effect. In this regard, in Non-Patent Literature 3, as a point to be noted, it is mentioned that in order to achieve this averaging effect, a multitude of longitudinal modes (i.e., ripples) caused by Fabry-Perot oscillation must not be present. Thus, to take advantage of the superiority of incoherent light pumping in forward-pumped Raman amplification, it is preferable for the incoherent light to be high-output and for the ripples to be suppressed.

In this regard, in the case of SOA, ripples occur due to the formation of a Fabry-Perot resonator between both end facets. Thus, ripples do not occur if the reflectivity at both end facets is zero. However, it is practically impossible to achieve zero reflectivity at both end facets of the SOA. Thus, suppressing ripples is an important challenge. Conventionally, techniques, such as (1) anti-reflection coating, (2) slanted waveguide structure, (3) window structure, have been used to suppress ripples. However, since a preferable pumping light source for Raman amplification has a high output of several hundred mW or more, even a slight reflection can cause ripples. Additionally, although the ASE light has a wide spectrum width of approximately several tens of nanometers, it is not easy to achieve an anti-reflection treatment with low reflectivity over this wide spectrum width. On the other hand, for example, Patent Literature 5 discloses a technique in which a mirror is provided behind the rear facet of the SOA to relax the requirement for the reflectivity of the anti-reflection coated end facet.

On the other hand, it is known that driving a semiconductor laser with a constant current in a driving current region sufficiently larger than the oscillation threshold, that is, in a saturation state, can suppress low-frequency noise (Non-Patent Literature 2). Similarly, it is known that ASE light emitted from an SOA, which is in a saturation state due to the input of large incoherent light, suppresses low-frequency RIN (Patent Literature 1, Non-Patent Literatures 6, 7, and 8).

Further, according to Non-Patent Literatures 3 and 4, the RIN transfer is more likely to occur on the low-frequency side, while it is cut off on the high-frequency side. In other words, there exists a cutoff frequency for the RIN transfer. Thus, the characteristics that low-frequency RIN is suppressed in the ASE light of the SOA in the saturation state are extremely beneficial from the viewpoint of reducing transmission characteristic deterioration due to the RIN transfer.

In Non-Patent Literature 8, FIGS. 2 and 3 illustrate that increasing the driving current (seed current and booster current) in the SOA in the saturation state significantly enhances the suppression of RIN. However, increasing the driving current of the SOA not only increases the optical power but also amplifies the ripples. Additionally, in an actual Raman amplification system, the Raman amplification gain is controlled by changing the output of the pumping light source. Thus, there is a need for a technique or means that allows for the suppression ripples to a small level without affecting the suppression of RIN even if the optical power of the SOA is changed.

In summary, the ASE light from the SOA presents a promising candidate as the incoherent pumping light source for Raman amplification considering its compact size and low cost, but it is desirable to simultaneously resolve the following conflicting challenges:

(1) High output power,
(2) Suppression of ripples caused by SOA end-facet reflection across a wide operating and output range of the pumping light source,
(3) Suppression of RIN over a wide operating range and output range of the pumping light source, and
(4) Low power consumption.

As a means to simultaneously address these challenges, an approach has been presented to amplify the relatively low-power ASE light from an SOA through secondary amplification using an FP oscillation-type pumping laser for Raman amplification (Patent Literature 7, Non-Patent Literature 9, 10, 11, and 12). This approach is effective for a long-distance, high-capacity Raman amplification and transmission system that requires higher gain. However, for a relatively short-distance system such as metro transmission system, direct pumping using ASE light from an SOA without the need for secondary pumping is desirable for simplifying the system, reducing costs, and minimizing power consumption.

The present invention has been made in view of the above and intended to provide a light source, a light source device, a method of driving the light source, and a Raman amplifier and Raman amplification system using the same, in which RIN and ripple are simultaneously suppressed.

Solution to Problem

To solve the above-described problem and achieve the object, a light source according to one aspect of the present invention includes: a seed light source configured to output incoherent seed light having a predetermined bandwidth; and a booster amplifier that is a semiconductor optical amplifier configured to optically amplify the seed light entered through a first end facet and output the amplified light through a second end facet, wherein the booster amplifier has nL being set, which is a product of a refractive index n and a chip length L, so as to simultaneously suppress relative intensity noise (RIN) and ripple in the amplified light.

The chip length L may be 1 mm or more.

The chip length L may be 1.5 mm or more.

The chip length L may be 2 mm or more.

The seed light source and the booster amplifier may be driven with a driving current used to simultaneously suppress the relative intensity noise (RIN) and the ripple in the amplified light.

The booster amplifier may be driven to operate in a gain saturation state.

The seed light source may be driven with the driving current that outputs the seed light with a power such that a power of the amplified light approaches a maximum.

The seed light source may include at least one of a super-luminescent diode (SLD), a semiconductor optical amplifier, and an amplified spontaneous emission (ASE) light source with a rare-earth-doped optical fiber.

The amplified light output by the booster amplifier may have the power of 100 mW or more.

The first end facet and the second end facet of the booster amplifier may have respective end-facet reflectivity in a range between $10^{-3}$ and $10^{-5}$.

A light source device according to one aspect of the present invention includes: the light source; and a driving device configured to drive the light source.

A method according to one aspect of the present invention of driving a light source including: a seed light source configured to output incoherent seed light having a predetermined bandwidth; and a booster amplifier that is a semiconductor optical amplifier configured to optically amplify the seed light entered through a first end facet and output the amplified light through a second end facet, includes: setting, in the booster amplifier, nL which is a product of a refractive index n and a chip length L, so as to simultaneously suppress relative intensity noise (RIN) and ripple in the amplified light; and driving the seed light source and the booster amplifier with a driving current used to simultaneously suppress the relative intensity noise (RIN) and the ripple in the amplified light.

A Raman amplifier according to one aspect of the present invention includes: the light source; and a Raman amplification optical fiber being input with the amplified light as pumping light.

A Raman amplification system according to one aspect of the present invention includes: the light source; and a Raman amplification optical fiber being input with the amplified light as pumping light.

Advantageous Effects of Invention

According to the present invention, a light source, a light source device, a method of driving the light source, and a Raman amplifier and Raman amplification system using the same are provided, in which RIN and ripple are simultaneously suppressed.

Brief Description of Drawings

FIG. 1 is a schematic diagram of a light source device according to a first embodiment.

FIG. 2 is a diagram illustrating a part of a light source module illustrated in FIG. 1.

FIG. 3 is a diagram illustrating an example of the power spectrum of output light of a booster amplifier.

FIG. 4 is a diagram illustrating an example of a power (Pf) of output light with respect to Ib.

FIG. 5 is a diagram illustrating an example of an RIN spectrum of output light.

FIG. 6 is a diagram schematically illustrating a spectrum in which RIN is suppressed.

FIG. 7 is a diagram illustrating an example of the power spectrum of output light when setting Is to 0 mA and varying Ib.

FIG. 8 is a diagram illustrating an example of the power spectrum of output light when varying Is.

FIG. 9 is a diagram illustrating an example of the Is dependence of the output light power (Pf) for Ib.

FIG. 10 is a diagram illustrating an example of the RIN spectrum of output light when varying Is.

FIG. 11 is a diagram illustrated to describe the relationship between suppression of RIN and suppression of ripples.

FIG. 12 is a diagram illustrating the suppression of Ripple in a case where a round-trip frequency falls within a RIN suppression area.

FIG. 13 is a diagram illustrating the center wavelengths of power spectra of output light of light source modules No. 11 to 31.

FIG. 14 is a diagram illustrating the ripple width with respect to Is of light source modules No. 11 to 31.

FIG. 15 is a schematic diagram of a Raman amplifier according to a second embodiment.

FIG. 16 is a schematic diagram of a Raman amplification system according to a third embodiment. Description of Embodiments

Embodiments of the present invention are now described with reference to the drawings. Moreover, the present invention is not limited to the embodiments described below. Furthermore, in the description of the drawings, the same parts are given the same reference numerals as appropriate, and redundant descriptions are appropriately omitted.

(First embodiment)

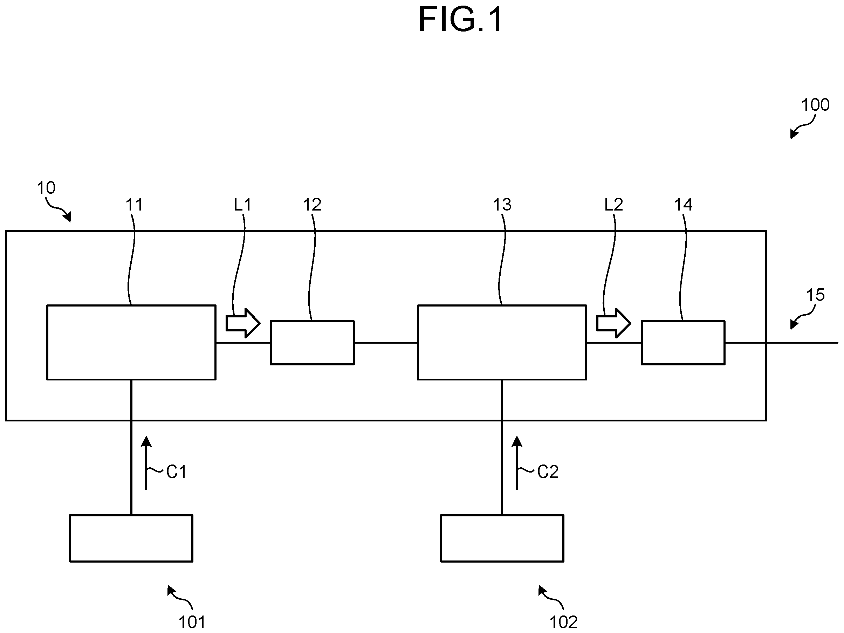

FIG. 1 is a schematic diagram of a light source device according to a first embodiment. This light source device 100 includes a light source module 10 and driving devices 101 and 102. The light source module 10 is an example of a light source.

The light source module 10 includes a seed light source 11 which is an SOA, an optical isolator 12, a booster amplifier 13 which is also an SOA, an optical isolator 14, and an output optical fiber 15. The seed light source 11, the optical isolator 12, the booster amplifier 13, and the optical isolator 14 are optically cascaded in this order using an optical fiber, an optical component, or the like.

The seed light source 11 outputs incoherent seed light L1 with a predetermined band. Incoherent light refers to light that is made up of a collection of uncorrelated photons with a continuous spectrum, rather than a laser light source that oscillates in a single or multiple discrete modes (longitudinal modes). The predetermined band is not particularly limited, and a wide band such as a wavelength bandwidth of, for example, 25 nm or more is preferable. The optical isolator 12 allows the seed light L1 to transmit, inputs the seed light L1 into the booster amplifier 13, and prevents return light traveling from the side of the booster amplifier 13 from entering the seed light source 11. The optical isolator 12 prevents or reduces the instability in the operation of the seed light source 11 caused by the input of return light.

The booster amplifier 13 optically amplifies the seed light L1 being input and outputs the result as amplified light L2. The optical isolator 14 transmits the amplified light L2 and inputs the amplified light L2 into the output optical fiber 15, and prevents the light traveling from the side of the output optical fiber 15 from entering the booster amplifier 13. The optical isolator 14 prevents or reduces the instability in the operation of the booster amplifier 13 caused by the input of return light.

The output optical fiber 15 is an optical fiber that guides the amplified light L2 to the outside of the light source module 10. The amplified light L2 is used, for example, as pumping light for Raman amplification.

The driving devices 101 and 102 are known driving devices for SOA. The driving device 101 supplies the seed light source 11 with a driving current C1. The driving device 102 supplies the booster amplifier 13 with a driving current C2.

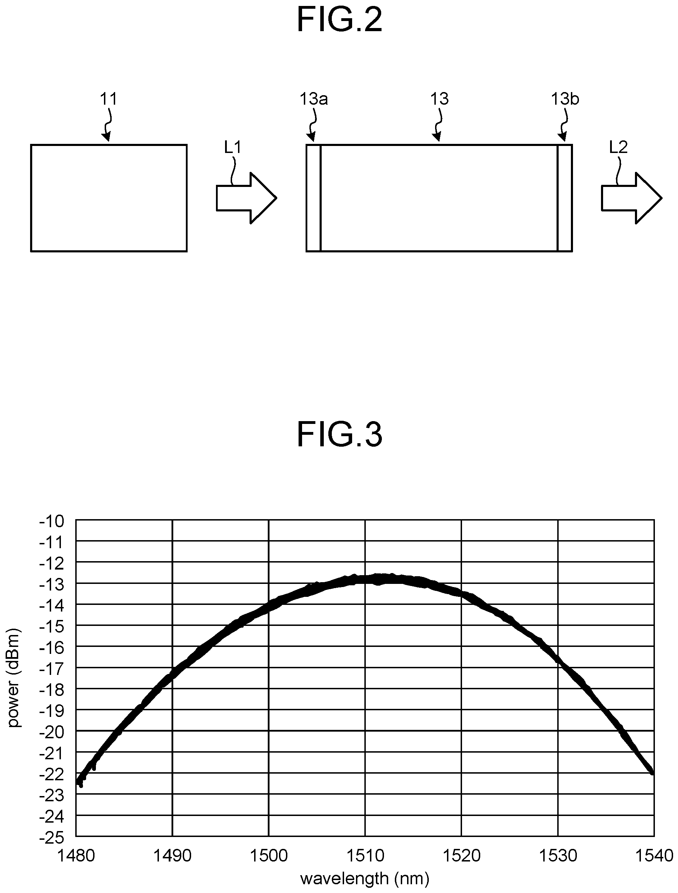

FIG. 2 is a diagram illustrating a part of the light source module 10 presented in FIG. 1. The booster amplifier 13 has a first end facet 13a and a second end facet 13b that face mutually. The booster amplifier 13 receives the seed light L1 through the first end facet 13a and outputs the amplified light L2 to the outside through the second end facet 13b.

The first end facet 13a and the second end facet 13b are subjected to a reflection reduction treatment such as anti-reflection (AR) coating. Additionally, the first end facet 13a and the second end facet 13b may be subjected to the reflection reduction treatment by being inclined relative to the optical axis of the optical amplification waveguide included in the booster amplifier 13. Such a structure is also called a slanted waveguide structure.

Assuming that the end-facet reflectivity of the first end facet 13a is denoted as R1 and the end-facet reflectivity of the second end facet 13b is denoted as R2, for example, R1 and R2 fall in a range between $10^{-3}$ and $10^{-5}$. Alternatively, $(R1 \times R2)^{1/2}$ falls in the range, for example, between $10^{-3}$ and $10^{-5}$. The range between $10^{-3}$ and $10^{-5}$ represents an example of a sufficiently practical and feasible numerical range in terms of low reflectivity. The range between $10^{-3}$ and $10^{-5}$ is herein a range that includes both $10^{-3}$ as the upper limit and $10^{-5}$ as the lower limit.

<Characteristics of light source module 10>

The characteristics of the light source module 10 is described. FIG. 3 is a diagram illustrating an example of the power spectrum of the output light (amplified light) from the booster amplifier. FIG. 3 illustrates a case of setting Is to 50 mA and setting Ib to 800 mA, where Is denotes the driving current C1 supplied to the seed light source 11, and Ib denotes the driving current C2 supplied to the booster amplifier 13. The power spectrum of the output light in FIG. 3 generally exhibits a Gaussian-shaped spectrum, with a full width half maximum (FWHM) of approximately 25 nm to 30 nm.

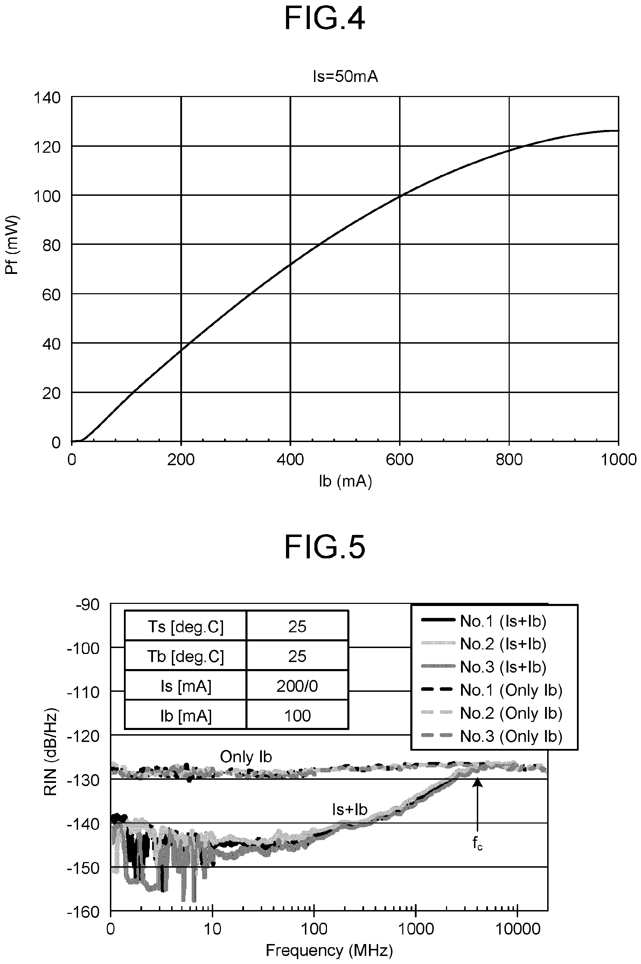

FIG. 4 is a diagram illustrating an example of the power (Pf) of the output light (amplified light) from the booster amplifier with respect to Ib. FIG. 4 illustrates a case of setting Is to 50 mA. In the case of FIG. 4, it can be seen that when Ib is 100 mA, Pf is approximately 20 mW, and when Ib is 800 mA, Pf is approximately 120 mW. Moreover, FIGS. 3 and 4 are examples of light source modules that are manufactured using semiconductor optical amplifiers with substantially similar characteristics as the seed light source and the booster amplifier.

In this regard, the inventors of the present invention have found that in the light source module 10 as illustrated in FIG. 1, by suitably setting the product of a refractive index n and a chip length L of the booster amplifier 13, denoted as nL, it is possible to achieve a state where RIN and ripple are simultaneously suppressed. The refractive index n of the booster amplifier 13 refers to the refractive index that acts on the seed light within the booster amplifier 13 until the seed light being input to the booster amplifier 13 is output as amplified light, which is the refractive index of the active layer of the booster amplifier 13. The following sequentially describes the suppression of RIN, the suppression of ripple, and then the relationship between suppression of RIN and suppression of ripple.

<Suppression of RIN>

FIG. 5 is a diagram illustrating an example of the RIN spectrum of the output light. Specifically, FIG. 5 illustrates the results obtained by measuring the RIN of the output light from light source modules No. 1 to 3, which are fabricated as examples of the light source module 10. Moreover, the light source modules No. 1 to 3 were made using semiconductor optical amplifiers with substantially similar characteristics as both the seed light source and the booster amplifier, and they have output characteristics equivalent to those illustrated in FIGS. 3 and 4. Additionally, for the light source modules No. 1 to 3, it was confirmed that the end-facet reflectivity, given by $(R1 \times R2)^{1/2}$, is in the range between $10^{-3}$ and $10^{-5}$. Furthermore, in FIG. 5, Ts indicates the case temperature of the seed light source (25°C), and Tb indicates the case temperature of the booster amplifier (25°C).

In FIG. 5, "only Ib" indicates the condition where a driving current of 100 mA is supplied only to the booster amplifier, and no driving current is supplied to the seed light source (i.e., the supplied driving current is 0 mA). In this case, since no seed light source to be amplified is input to the booster amplifier, it operates merely as an ASE light source. On the other hand, "Is + Ib" indicates the condition where the driving current of 100 mA is supplied to the booster amplifier and a driving current of 200 mA is supplied to the seed light source.

As can be seen from FIG. 5, in the case of "only Ib", a relatively flat RIN spectrum was obtained for all of the light source modules No. 1 to 3. This RIN is considered to originate from the ASE-to-ASE beat noise in the output light (ASE light) emitted from the booster amplifier as the ASE light source.

On the other hand, in the case of "Is + Ib", it can be seen that for all of the light source modules No. 1 to 3, RIN is suppressed at a specific frequency fc and below. Moreover, in the case of "Is + Ib", the seed light (ASE light) emitted by the seed light source is input to the booster amplifier, increasing the internal photon number, and so the booster amplifier is considered to be operating in a gain saturation state. In this regard, notably, in FIG. 5, despite Ib being a relatively low current of 100 mA and the power of the output light from the booster amplifier being a comparatively low driving state, it is already in a state of suppression of RIN. This point will be described in detail later.

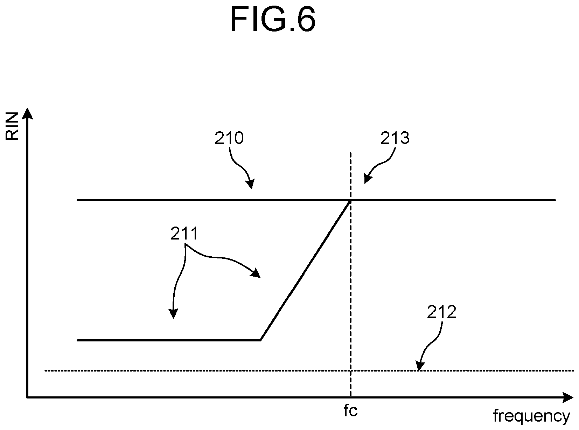

FIG. 6 is a diagram schematically illustrating a spectrum in which RIN is suppressed. In this regard, since the output light emitted from the light source, such as the light source module in the embodiment, is ASE light from an SOA, its RIN is supposed to be determined by the magnitude of the ASE-to-ASE beat noise. In FIG. 6, the level of a line 210 represents the level of the ASE-to-ASE beat noise.

The power spectrum width of the ASE light of a typical SOA spans several tens of nanometers, which corresponds to a several THz in frequency. The measurement bandwidth for RIN is sufficiently small as several tens of GHz, so RIN is calculated using the following Equation (1) (Non-Patent Literature 15):

$$\mathrm{RIN} = 0.66/\Delta\nu_{\mathrm{ASE}}\,[\mathrm{Hz}^{-1}] \quad (1)$$

In this Equation, 0.66 is the coefficient in the case where the power spectrum of the ASE light is Gaussian, and $\Delta\nu_{ASE}$ is the FWHM of the power spectrum.

For example, the power spectrum of the output light illustrated in FIG. 3 is Gaussian with an FWHM of approximately 30 nm, and so using the above Equation (1), RIN is calculated to be approximately -127 dB/Hz. This value roughly matches the result illustrated in FIG. 5.

On the other hand, the RIN of the SOA operating in the gain saturation state is suppressed in a frequency region 211 lower than fc, also called a corner frequency 213. For example, the suppression of RIN of approximately 10 dB to 20 dB from the level of the line 210 has been reported (Patent Literature 1, Non-Patent Literatures 6 and 8). Moreover, a line 212 is the level of shot noise.

Herein, the suppression of RIN means that the RIN is suppressed by 10 dB or more compared to the RIN calculated using the above Equation (1). The degree of suppression of RIN may further be 16 dB or less, or even 20 dB or less.

<Suppression of ripple>

The suppression of ripple is now described. Specifically, the power spectrum of the output light from the light source module (referred to as light source module No. 4) with equivalent output characteristics to the light source module No. 1 was measured while varying the driving conditions of the seed light source and the booster amplifier.

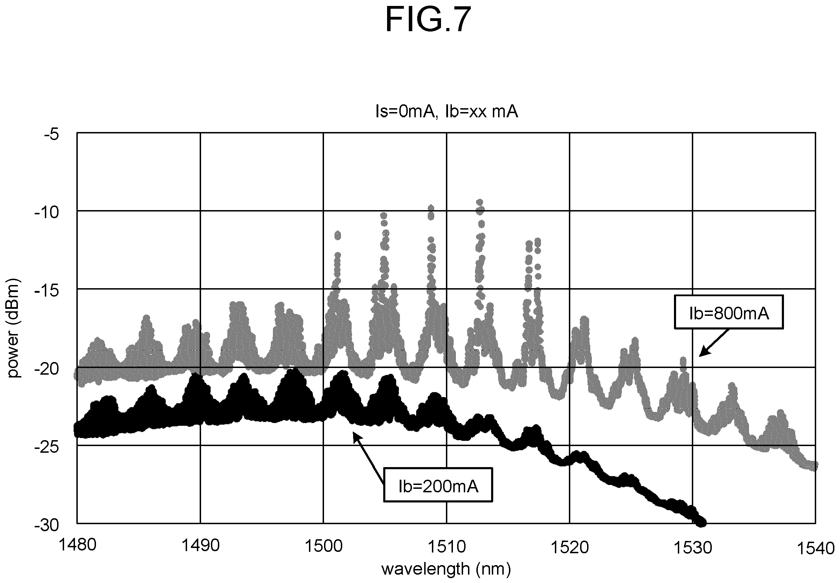

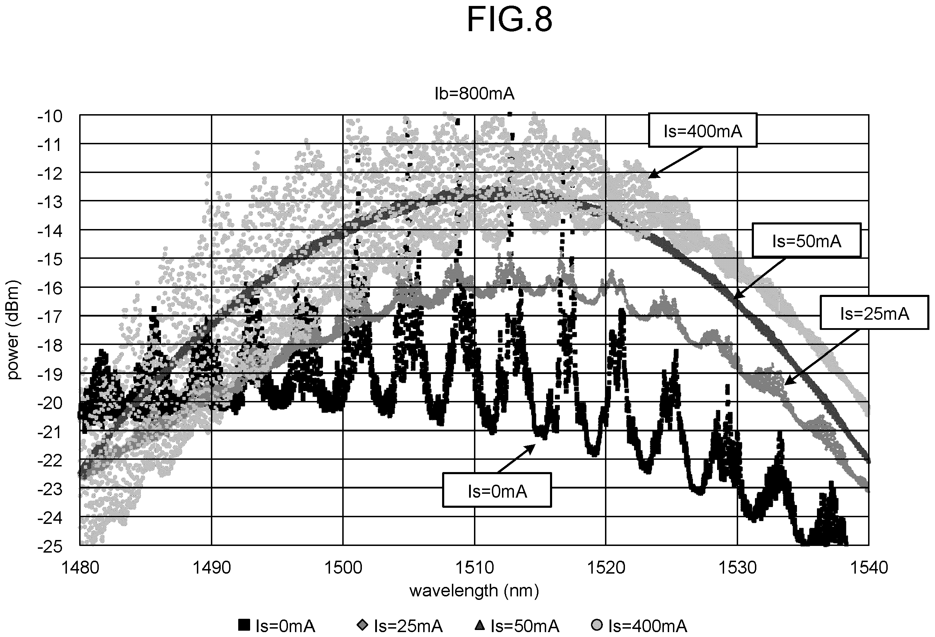

FIG. 7 is a diagram illustrating an example of the power spectrum of output light when setting Is to 0 mA and varying Ib. FIG. 8 is a diagram illustrating an example of the power spectrum of output light when varying Is.

In FIG. 7, a ripple occurs in both cases when Ib is 200 mA and 800 mA. In particular, in the case where Ib is 200 mA, a ripple occurs despite the power of the output light being relatively low, approximately 18 mW. Additionally, a ripple was particularly likely to occur in the case of Is being set to 0 mA. As mentioned above, this ripple is attributed to the reflection of light on both end facets of the SOA, but it occurs despite the end-facet reflectivity of the booster amplifier being in a sufficiently low range between $10^{-3}$ and $10^{-5}$ as given by $(R1 \times R2)^{1/2}$. The fact that a ripple occurs despite such a low driving current (low power) and low reflectivity is an example of how difficult it is to suppress a ripple in a pumping light source for Raman amplification, which has an optical power of several hundred mW in some cases. Moreover, the ripple included components of multiple different periods.

On the other hand, as illustrated in FIG. 8, fixing Ib at 800 mA and increasing Is to 25 mA suppress the ripple, and increasing Is to 50 mA further suppresses the ripple. However, further increasing Is to 400 mA causes the ripple to increase again.

As illustrated in FIG. 8, if the seed light is input to the booster amplifier, it reaches the gain saturation state, where a region of suppressed ripple exists. This indicates that ripples can be suppressed by controlling the power of the seed light that is input to the booster amplifier without lowering the end-facet reflectivity of the booster amplifier to such an extent that ripples are suppressed. Moreover, since the ASE light spectrum of the SOA is wide ranging from several nanometers to several tens of nanometers, it is not easy to perform treatment to reduce the end-facet reflectivity (e.g., anti-reflection treatment) so as to cover such a wide band. Thus, the technology of controlling the power of the seed light to suppress ripple is an approach capable of alleviating the conditions for setting the end-facet reflectivity of the booster amplifier and the difficulty in manufacturing it, and so it is a highly effective technology in practice.

It is preferable to suppress ripples as the ripple becomes smaller. The magnitude of the ripple is indicated by the maximum value of the ripple width (peak-to-bottom) appearing on the power spectrum at a predetermined wavelength (e.g., around 1510 nm). In this case, it is preferable to suppress the ripple so that the width of the ripple from peak to bottom is, for example, 5 dB or less, or even 3 dB or less, 1 dB or less, or 0.5 dB or less.

Thus, in a method of driving a light source module as a light source, it is preferable to drive the seed light source and the booster amplifier with driving currents (Is and Ib) that simultaneously suppress RIN and ripple in the amplified light.

<Is dependence of RIN spectrum>

Next, the light source module No. 4 indicating ripple characteristics in FIGS. 7 and 8 is described in terms of Is dependence.

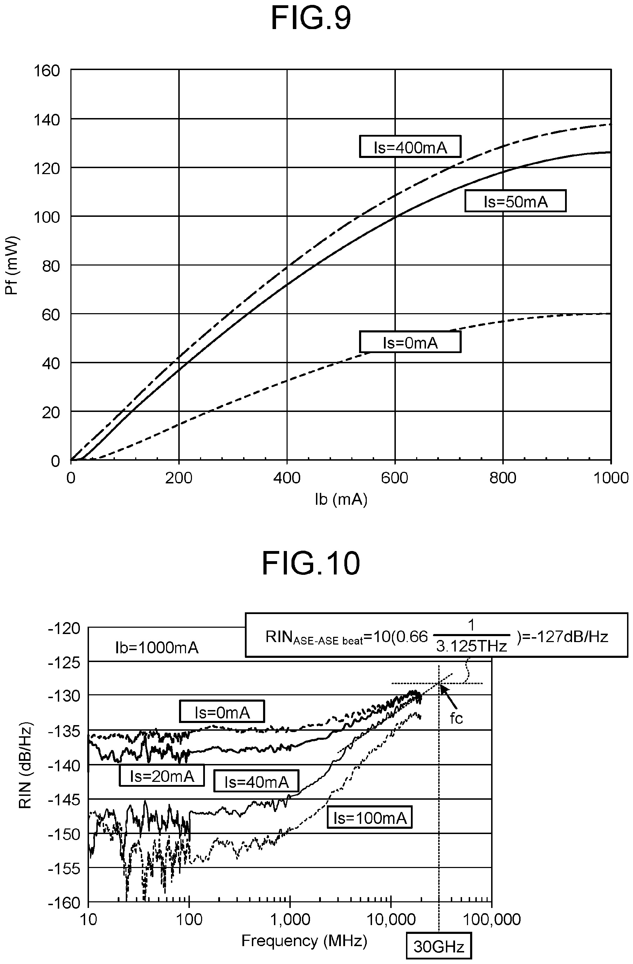

FIG. 9 is a diagram illustrating an example of the Is dependence of the output light power (Pf) for Ib. Comparing the curve at Is = 0 mA in FIG. 9 with FIG. 7, it can be seen that at Ib = 200 mA, although Pf is small at approximately 18 mW, which is approximately one-third of the maximum output of approximately 60 mW, as illustrated in FIG. 7, ripples are occurring. Additionally, at Ib = 800 mA, although Pf is close to the maximum output, it can be seen that the width of the ripple, as illustrated in FIG. 7, is 10 dB or more from peak to bottom.

On the other hand, FIG. 10 is a diagram illustrating an example of the RIN spectrum of output light when varying Is. Moreover, Ib was fixed at 1000 mA. As can be seen from FIG. 10, RIN is suppressed as Is increases. This is considered to be because the degree of gain saturation of the booster amplifier grows as Is increases.

In FIG. 10, the ASE-to-ASE beat noise level ($RIN_{ASE\text{-}ASE\ beat}$) was calculated to be -127 dB/Hz based on the above Equation (1). Thus, by extending the line of the graph at Is = 40 mA to the high-frequency side like a broken line and examining the corner frequency fc from the intersection of the extended line and the level of $RIN_{ASE\text{-}ASE\ beat}$ level (dashed line), it was found to be approximately 30 GHz. Moreover, by using similar lines in the graph for other values of Is and examining fc, it found to be approximately 30 GHz. From this, it was confirmed that RIN is suppressed on the side of low frequency from at least approximately 30 GHz in the light source module No. 4.

<Relationship between suppression of RIN and suppression of ripple>

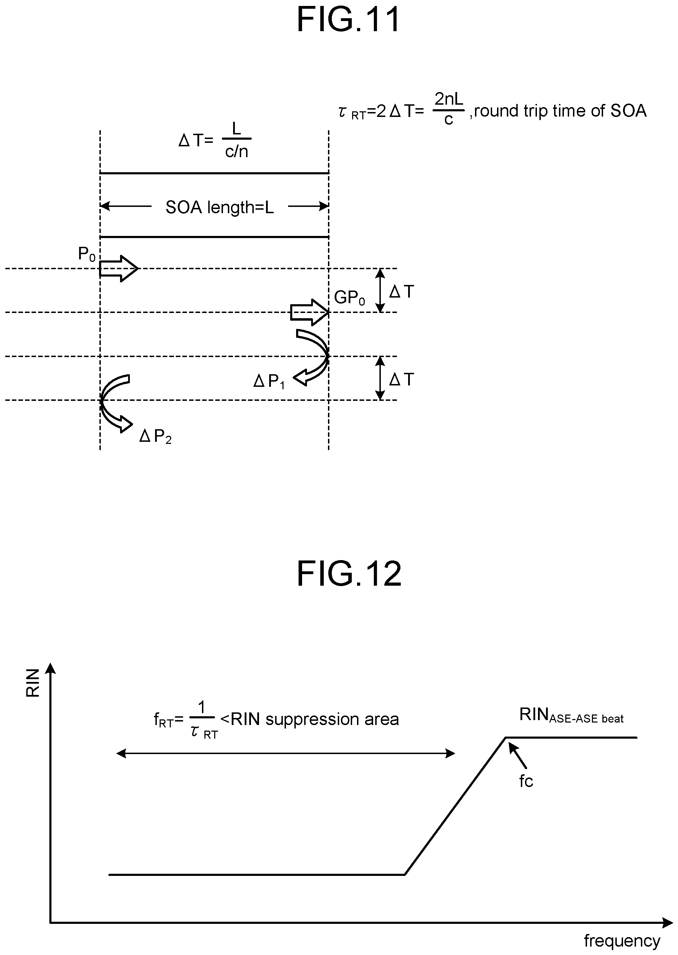

The inventor of the present invention has considered the relationship between suppression of RIN and suppression of ripple as follows. FIG. 11 is a diagram illustrated to describe the relationship between suppression of RIN and suppression of ripple. In FIG. 11, the chip of an SOA constituting the booster amplifier 13 is illustrated. The chip length of the SOA is denoted as L. The seed light with power Po that is input through the first end facet of the SOA is amplified while propagating through the SOA, receives a gain G, becomes amplified light with power $GP_0$, and reaches the second end facet after a time $\Delta T$ has elapsed. Then, a part of the amplified light is reflected at the second end facet, and the first reflected light with power $\Delta P_1$ propagates toward the first end facet. The first reflected light with the power $\Delta P_1$ is amplified while propagating through the SOA, and reaches the first end facet after a time $\Delta T$ has elapsed. Then, a part of the first reflected light is reflected at the first end facet, becoming the second reflected light with power $\Delta P_2$, which further propagates towards the second end facet. In this way, a part of the light is reflected at the end facet and propagated, causing fluctuations in optical power due to the reflection. This fluctuation causes a ripple.

The time for the fluctuations in optical power to traverse the SOA constituting the booster amplifier 13 back and forth is referred to as $\tau_{RT}$ (round trip time). If $\tau_{RT}$ is expressed in frequency, it becomes $f_{RT} = 1/\tau_{RT}$. Hereinafter, $f_{RT}$ may be referred to as round-trip frequency.

Using the following Equation (2), $\tau_{RT}$ is defined by the length L of the SOA chip and the refractive index n. Furthermore, Equation (3) holds from Equation (2).

$$\tau_{RT} = (2nL/c) \quad (2)$$

$$f_{RT} = 1/\tau_{RT} = (c/2nL) \quad (3)$$

FIG. 12 is a diagram illustrating the suppression of ripple in the case where the round-trip frequency falls within a RIN suppression area. The inventor of the present invention has discovered that if the round-trip frequency $f_{RT}$, which is the fluctuation frequency, falls within a RIN suppression frequency band (RIN suppression area), the fluctuation is suppressed, thereby restraining the occurrence of ripples. As can be seen from Equations (2) and (3), $f_{RT}$ depends on the refractive index n and the chip length L. Thus, it is preferable that the product of the refractive index n and the chip length L, nL, is set in the booster amplifier 13 so that both the RIN and ripple are suppressed simultaneously in the amplified light.

In this regard, In the light source module No. 4, it can be assumed that the chip length L is 1.8 mm and the refractive index n is 3.5. In this case, $f_{RT}$ is 23.8 GHz, which falls within the range of the RIN suppression frequency band, i.e., frequencies lower than fc as illustrated in FIG. 10. Thus, nL = 3.5 × 1.8 = 6.3 is a preferable example of nL.

Further, in the case where the refractive index n is set to 3.5, an example of the relationship between the chip length L and $f_{RT}$ is illustrated in Table 1. The chip length L is preferably 1 mm or more, more preferably 1.5 mm or more, and even more preferably 2 mm or more. Moreover, the refractive index n depends on the oscillation wavelength and the composition ratio of the active layer, so it should be noted that Table 1 is just an example.

Table 1

| SOA chip length L (mm) | $f_{RT}$ (GHz) |
|---|---|
| 1.0 | 42 |
| 1.5 | 29 |
| 1.8 | 24 |
| 2.0 | 21 |
| 3.0 | 14 |

The RIN suppression frequency band is determined by the Ib or saturation state of the booster amplifier 13 (Non-Patent Literature 8). Additionally, while the refractive index of the booster amplifier 13 depends on factors such as the wavelength of the seed light and the composition ratio of the active layer, it generally ranges from 3.2 to 3.6, and the specific suitable chip length L is determined by the RIN suppression frequency band and the refractive index of the booster amplifier 13. From the viewpoint of ripple suppression, there is no upper limit to the value of L, but considering the internal loss of the SOA chip and the overall size of the light source module 10, a value of around 5 mm or less is preferable.

As described above, while the ripple is suppressed by the RIN suppression phenomenon, it is natural assumed that the reflectivity of the first end facet 13a and the reflectivity of the second end facet 13b of the booster amplifier 13 are low enough to achieve the ripple suppression effect by suppressing the RIN. Moreover, the reflectivity of the first end facet and the reflectivity of the second end facet in the light source modules No. 1 to 4 described above are approximately within the range of $(R1 \times R2)^{1/2}$ between $10^{-3}$ and $10^{-5}$, which is sufficiently low for practical use. Nevertheless, the pumping light source for Raman amplification generally requires outputs of several hundred mW or more, making the ripple easy to occur. However, as described herein, by ensuring that the round-trip frequency derived from nL, which is the product of the chip length L and the refractive index n, falls within the RIN suppression frequency band, the ripple is suppressed even within the range of end-facet reflectivity that is widely used in practical use.

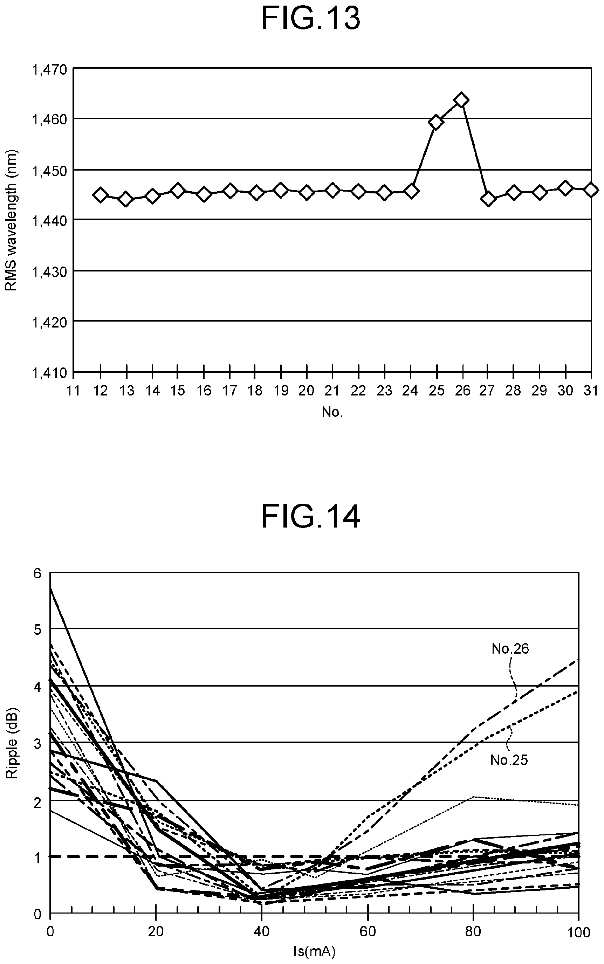

Subsequently, the ripple characteristics of light source modules (referred to as light source modules No. 11 to 31) having equivalent output characteristics to the light source module No. 4 are described. FIG. 13 illustrates a center wavelength of the output light power spectrum of the light source modules No. 11 to 31. Moreover, the center wavelength was measured using the RMS technique.

In the light source modules No. 11 to 31, the chip length of the booster amplifier is uniformly 1.8 mm. However, as illustrated in FIG. 13, the light source modules No. 25 and 26 have longer peak wavelengths than the other light source modules. The reason for this is that in the light source modules No. 25 and 26, the refractive index of the booster amplifier is relatively low.

FIG. 14 is a diagram illustrating the width of the ripple with respect to Is of the light source modules No. 11 to 31. Moreover, Ib is fixed at a predetermined value. As illustrated in FIG. 14, the width of the ripple in the light source modules No. 25 and 26 is larger than that of the other light source modules. The reason for this is that while the oscillation wavelengths of the light source modules No. 25 and 26 are longer than those of other light source modules, the refractive index of InP-based semiconductor materials has a negative correlation with wavelength, and so it is believed that nL of the booster amplifier becomes smaller than nL in other light source modules.

As described above, the light source device and light source module according to the embodiments simultaneously suppress RIN and ripple in the amplified light by appropriately setting nL which is the product of the refractive index n and the chip length L of the booster amplifier, and thus, it is suitable as a pumping light source for Raman amplification, especially as a pumping light source for forward pumping, and is particularly excellent in suppressing RIN and suppressing RIN transfer.

(Second embodiment)

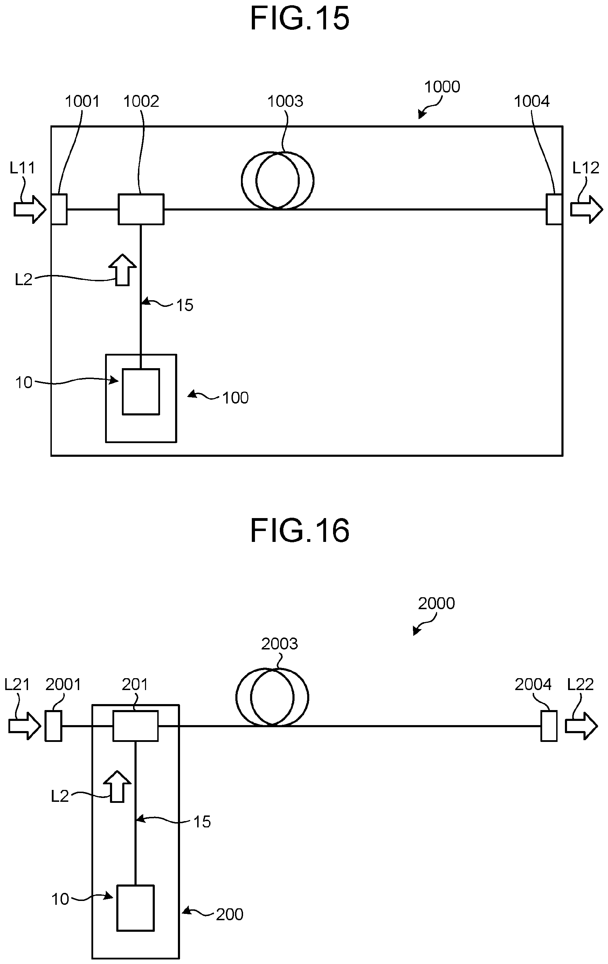

FIG. 15 is a schematic diagram of a Raman amplifier according to a second embodiment. The Raman amplifier 1000 is configured as a forward-pumped distributed optical amplifier that includes the light source module 10 of the first embodiment as a pumping light source. The Raman amplifier 1000 includes the light source device 100 provided with the light source module 10, a signal light input unit 1001, an optical multiplexer 1002, a Raman amplification optical fiber 1003 such as a highly nonlinear optical fiber, and a Raman amplified light output unit 1004.

The signal light input unit 1001 receives signal light L11. The optical multiplexer 1002 multiplexes the signal light L11 with the amplified light L2, which is output from the output optical fiber 15 of the light source module 10 and is used as pumping light, and inputs the multiplexed signal into the Raman amplification optical fiber 1003. The Raman amplification optical fiber 1003 uses the amplified light L2 as the pumping light to amplify the signal light L11 through Raman amplification. The Raman amplified light output unit 1004 outputs Raman amplified light L12, which is light obtained by amplifying the signal light L11 through Raman amplification.

The amplified light L2 from the light source module 10 is set to a wavelength that allows the Raman amplification optical fiber 1003 to amplify the signal light L11 through Raman amplification.

The Raman amplifier 1000 is particularly excellent in suppressing RIN and suppressing RIN transfer.

(Third embodiment)

FIG. 16 is a schematic diagram of a Raman amplification system according to a third embodiment. The Raman amplification system 2000 is configured as a forward-pumped distributed optical amplification system that includes the light source module 10 of the first embodiment as a pumping light source. The Raman amplification system 2000 includes a light source device 200 provided with the light source module 10, a signal light input unit 2001, a Raman amplification optical fiber 2003 such as a standard single-mode fiber, dispersion-shifted fiber, or non-zero dispersion-shifted fiber, and a Raman amplified light output unit 2004. The standard single-mode fiber is, for example, an optical fiber conforming to the ITU-T G.652 standard.

The light source device 200 has a configuration that includes an optical multiplexer 201 in addition to the light source device 100. Additionally, as for the Raman amplification optical fiber 2003, for example, an optical fiber for optical communication installed in the field can be used.

The signal light input unit 2001 receives signal light L21. The optical multiplexer 201 multiplexes the signal light L11 with the amplified light L2, which is output from the output optical fiber 15 of the light source module 10 and is used as pumping light, and inputs the multiplexed light into the Raman amplification optical fiber 2003. The Raman amplification optical fiber 2003 uses the amplified light L2 as pumping light to amplify the signal light L21 through Raman amplification. The Raman amplified light output unit 2004 outputs Raman amplified light L22, which is light obtained by amplifying the signal light L21 through Raman amplification.

The amplified light L2 from the light source module 10 is set to a wavelength that allows the Raman amplification optical fiber 2003 to amplify the signal light L21 through Raman amplification.

The Raman amplification system 2000 is particularly excellent in suppressing RIN and suppressing RIN transfer.

Although the Raman amplifier and Raman amplification system of the embodiments described above are configured as a forward-pumped type, the embodiments of the present invention are not limited to this configuration and may also be configured as a backward-pumped or bidirectional-pumped type.

Further, the light source modules and light source devices of the embodiments described above can be widely used not only as a pumping light source for Raman amplification but also as a light source in which RIN and ripple are simultaneously suppressed.

Additionally, in the embodiments described above, the seed light is ASE light, but it may also be incoherent light such as spontaneous emission (SE).

Furthermore, in the above embodiments, the seed light source is a semiconductor optical amplifier, but it may also include at least one of a super-luminescent diode (SLD), an SOA, and an ASE light source equipped with a rare-earth-doped optical fiber. Such SLD, SOA and ASE light sources are suitable as incoherent light sources.

In addition, the present invention is not limited to the embodiments described above. Combinations of the various components described above are also included in the present invention. Moreover, further effects and modifications can be easily derived by those skilled in the art. Accordingly, the broader aspects of the invention are not limited to the embodiments described above, and various modifications are possible.

Industrial Applicability

The present invention can be utilized for a light source, a light source device, a method of driving the light source, a Raman amplifier, and a Raman amplification system.

Reference Signs List

10 LIGHT SOURCE MODULE
11 SEED LIGHT SOURCE
12, 14 OPTICAL ISOLATOR
13 BOOSTER AMPLIFIER
13a FIRST END FACET
13b SECOND END FACET
15 OUTPUT OPTICAL FIBER
100, 200 LIGHT SOURCE DEVICE
101, 102 DRIVING DEVICE
1000 RAMAN AMPLIFIER
1001, 2001 SIGNAL LIGHT INPUT UNIT
1002, 201 OPTICAL MULTIPLEXER
1003, 2003 RAMAN AMPLIFICATION OPTICAL FIBER
1004, 2004 RAMAN AMPLIFIED LIGHT OUTPUT UNIT
2000 RAMAN AMPLIFICATION SYSTEM
C1, C2 DRIVING CURRENT
L1 SEED LIGHT
L11, L21 SIGNAL LIGHT
L12, L22 RAMAN AMPLIFIED LIGHT
L2 AMPLIFIED LIGHT

**Claims**

**1.** A light source comprising:

a seed light source configured to output incoherent seed light having a predetermined bandwidth; and
a booster amplifier that is a semiconductor optical amplifier configured to optically amplify the seed light entered through a first end facet and output the amplified light through a second end facet, wherein
the booster amplifier has nL being set, which is a product of a refractive index n and a chip length L, so as to simultaneously suppress relative intensity noise (RIN) and ripple in the amplified light.

**2.** The light source according to claim 1, wherein the chip length L is 1 mm or more.

**3.** The light source according to claim 1, wherein the chip length L is 1.5 mm or more.

4. The light source according to claim 1, wherein the chip length L is 2 mm or more.

5. The light source according to any one of claims 1 to 4, wherein the seed light source and the booster amplifier are driven with a driving current used to simultaneously suppress the relative intensity noise (RIN) and the ripple in the amplified light.

6. The light source according to any one of claims 1 to 5, wherein the booster amplifier is driven to operate in a gain saturation state.

7. The light source according to any one of claims 1 to 6, wherein the seed light source is driven with the driving current that outputs the seed light with a power such that a power of the amplified light approaches a maximum.

8. The light source according to any one of claims 1 to 7, wherein the seed light source includes at least one of a superluminescent diode (SLD), a semiconductor optical amplifier, and an amplified spontaneous emission (ASE) light source with a rare-earth-doped optical fiber.

9. The light source according to any one of claims 1 to 8, wherein the amplified light output by the booster amplifier has the power of 100 mW or more.

10. The light source according to any one of claims 1 to 9, wherein the first end facet and the second end facet of the booster amplifier have respective end-facet reflectivity in a range between $10^{-3}$ and $10^{-5}$.

11. A light source device comprising:

the light source according to any one of claims 1 to 10; and
a driving device configured to drive the light source.

12. A method of driving a light source including: a seed light source configured to output incoherent seed light having a predetermined bandwidth; and a booster amplifier that is a semiconductor optical amplifier configured to optically amplify the seed light entered through a first end facet and output the amplified light through a second end facet, the method comprising:

setting, in the booster amplifier, nL which is a product of a refractive index n and a chip length L, so as to simultaneously suppress relative intensity noise (RIN) and ripple in the amplified light; and
driving the seed light source and the booster amplifier with a driving current used to simultaneously suppress the relative intensity noise (RIN) and the ripple in the amplified light.

13. A Raman amplifier comprising:

the light source according to any one of claims 1 to 10; and
a Raman amplification optical fiber being input with the amplified light as pumping light.

14. A Raman amplification system comprising:

the light source according to any one of claims 1 to 10; and
a Raman amplification optical fiber being input with the amplified light as pumping light.

100
15
14
L2
13
12
L1
11
10
C2
C1
102
101

FIG.1

FIG.2

11
13a
13
13b
L1
L2

FIG.3

-10
-11
-12
-13
-14
-15
-16
-17
-18
-19
-20
-21
-22
-23
-24
-25
power (dBm)
1480
1490
1500
1510
1520
1530
1540
wavelength (nm)

# FIG.4

Is=50mA
Pf (mW)
140
120
100
80
60
40
20
0
0
200
400
600
800
1000
Ib (mA)

# FIG.5

-90
-100
-110
-120
-130
-140
-150
-160
RIN (dB/Hz)
Ts [deg.C] 25
Tb [deg.C] 25
Is [mA] 200/0
Ib [mA] 100
No.1 (Is+Ib)
No.2 (Is+Ib)
No.3 (Is+Ib)
No.1 (Only Ib)
No.2 (Only Ib)
No.3 (Only Ib)
Only Ib
Is+Ib
$f_c$
0
10
100
1000
10000
Frequency (MHz)

# FIG.6

RIN
210
213
211
212
fc
frequency

Is=0mA, Ib=xx mA
Ib=800mA
Ib=200mA
power (dBm)
-5
-10
-15
-20
-25
-30
wavelength (nm)
1480
1490
1500
1510
1520
1530
1540

FIG.7

FIG.8
Ib=800mA
Is=400mA
Is=50mA
Is=25mA
Is=0mA
power (dBm)
-10
-11
-12
-13
-14
-15
-16
-17
-18
-19
-20
-21
-22
-23
-24
-25
1480
1490
1500
1510
1520
1530
1540
wavelength (nm)
Is=0mA
Is=25mA
Is=50mA
Is=400mA

# FIG.9

160
140
120
100
80
60
40
20
0
Pf (mW)
0
200
400
600
800
1000
Ib (mA)
Is=400mA
Is=50mA
Is=0mA

# FIG.10

$RIN_{ASE\text{-}ASE\ beat}=10(0.66\ \frac{1}{3.125THz})=-127dB/Hz$
Ib=1000mA
-120
-125
-130
-135
-140
-145
-150
-155
-160
RIN (dB/Hz)
Is=0mA
Is=20mA
Is=40mA
Is=100mA
fc
10
100
1,000
10,000
100,000
Frequency (MHz)
30GHz

# FIG.11

$\tau_{RT}=2\Delta T=\frac{2nL}{c}$ ,round trip time of SOA
$\Delta T=\frac{L}{c/n}$
SOA length=L
$P_0$
$GP_0$
$\Delta T$
$\Delta P_1$
$\Delta T$
$\Delta P_2$

# FIG.12

RIN
$f_{RT}=\frac{1}{\tau_{RT}}$ <RIN suppression area
$RIN_{ASE\text{-}ASE\ beat}$
fc
frequency

# FIG.13

1,470
1,460
1,450
1,440
1,430
1,420
1,410
RMS wavelength (nm)
11 12 13 14 15 16 17 18 19 20 21 22 23 24 25 26 27 28 29 30 31
No.

# FIG.14

6
5
4
3
2
1
0
Ripple (dB)
No.26
No.25
0 20 40 60 80 100
Is(mA)

FIG.15

1000
1001
1002
1003
1004
L11
L12
L2
15
10
100

FIG.16

2000
2003
L21
2001
201
2004
L22
L2
15
10
200

# INTERNATIONAL SEARCH REPORT

International application No.
**PCT/JP2022/045183**

## A. CLASSIFICATION OF SUBJECT MATTER

***H01S 5/50***(2006.01)i; ***G02F 1/35***(2006.01)i; ***H01S 3/0933***(2006.01)i; ***H01S 5/042***(2006.01)i
FI: H01S5/50 610; G02F1/35 501; H01S3/0933; H01S5/042 630

According to International Patent Classification (IPC) or to both national classification and IPC

## B. FIELDS SEARCHED

Minimum documentation searched (classification system followed by classification symbols)

H01S5/50; G02F1/35; H01S3/0933; H01S5/042

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

Science Direct; IEEE Xplore; Wiley Online Library; Scopus; SPIE Digital Library; OSA Publishing

## C. DOCUMENTS CONSIDERED TO BE RELEVANT

| Category* | Citation of document, with indication, where appropriate, of the relevant passages | Relevant to claim No. |
|---|---|---|
| A | WO 2016/182068 A1 (THE FURUKAWA ELECTRIC CO., LTD.) 17 November 2016 (2016-11-17)<br>entire text, all drawings | 1-14 |
| A | JP 2013-504216 A (AXSUN TECHNOLOGIES INC.) 04 February 2013 (2013-02-04)<br>entire text, all drawings | 1-14 |
| A | JP 2005-123612 A (SAMSUNG ELECTRONICS CO., LTD.) 12 May 2005 (2005-05-12)<br>entire text, all drawings | 1-14 |
| A | WO 2016/194556 A1 (HAMAMATSU PHOTONICS KK) 08 December 2016 (2016-12-08)<br>entire text, all drawings | 1-14 |
| A | US 2014/0153083 A1 (MASSACHUSETTS INSTITUTE OF TECHNOLOGY) 05 June 2014 (2014-06-05)<br>entire text, all drawings | 1-14 |
| A | US 2005/0185262 A1 (YUN, In-Kuk) 25 August 2005 (2005-08-25)<br>entire text, all drawings | 1-14 |

☑ Further documents are listed in the continuation of Box C. ☑ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **17 January 2023** | **07 February 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

INTERNATIONAL SEARCH REPORT

International application No. PCT/JP2022/045183

C. DOCUMENTS CONSIDERED TO BE RELEVANT

| Category* | Citation of document, with indication, where appropriate, of the relevant passages | Relevant to claim No. |
|---|---|---|
| A | KOBAYASHI, T. et al. PDM-16QAM WDM Transmission with 2nd-Order Forward-Pumped Distributed Raman Amplification Utilizing Incoherent Pumping. Optical Fiber Communication Conference, 2019, Tu3F.6, pp. 1-3<br>entire text, all drawings | 1-14 |
| A | MORIMOTO, Masahito et. al Co-Propagating Dual-Order Distributed Raman Amplifier Utilizing Incoherent Pumping. IEEE Photonics Technology Letters, 2017, vol. 29, no. 7, pp. 567-570<br>entire text, all drawings | 1-14 |
| P, A | WO 2022/054860 A1 (THE FURUKAWA ELECTRIC CO., LTD.) 17 March 2022 (2022-03-17)<br>entire text, all drawings | 1-14 |

Form PCT/ISA/210 (second sheet) (January 2015)

## INTERNATIONAL SEARCH REPORT
**Information on patent family members**

International application No.
**PCT/JP2022/045183**

| Patent document cited in search report | Publication date (day/month/year) | Patent family member(s) | Publication date (day/month/year) |
|---|---|---|---|
| WO 2016/182068 A1 | 17 November 2016 | US 2018/0123311 A1<br>entire text, all drawings<br>CN 107533270 A | |
| JP 2013-504216 A | 04 February 2013 | US 2011/0051148 A1<br>entire text, all drawings<br>WO 2011/028999 A2<br>EP 2473838 A2<br>CN 102695951 A | |
| JP 2005-123612 A | 12 May 2005 | US 2005/0078359 A1<br>entire text, all drawings<br>KR 10-2005-0035580 A<br>CN 1607412 A | |
| WO 2016/194556 A1 | 08 December 2016 | US 2018/0156860 A1<br>entire text, all drawings<br>EP 3306761 A1<br>CN 107615603 A<br>KR 10-2018-0013937 A | |
| US 2014/0153083 A1 | 05 June 2014 | (Family: none) | |
| US 2005/0185262 A1 | 25 August 2005 | KR 10-2005-0061106 A | |
| WO 2022/054860 A1 | 17 March 2022 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20140153083 A
- US 07190861 B
- US 07215836 B
- US 07236295 B
- US 07173757 B
- JP 4069110 B
- US 10938175 B


### Non-patent literature cited in the description


- **FLUDGER, C. R. S. ; HANDEREK, V. ; MEARS, R. J.** Pump to signal RIN transfer in Raman fiber amplifiers. *Journal of Lightwave Technology,* 2001, vol. 19 (8), 1140
- Raman amplification using high-power incoherent semiconductor pump sources. **VAKHSHOORI, D et al.** Optical Fiber Communication Conference. Optical Society of America, 2003, PD47
- Noise suppression and intensity modulation using gain-saturated semiconductor optical amplifier. **YAMATOYA, T. ; KOYAMA, F ; IGA, K.** Optical Amplifiers and Their Applications. Optical Society of America, 2000, OMD12
- High power superluminescent diodes for multi-wavelength light sources. In: Conference Proceedings. LEOS'97. **KOYAMA, F.** 10th Annual Meeting IEEE Lasers and Electro-Optics Society 1997 Annual Meeting. IEEE, 1997, 333-334
- **ZHAO, MINGSHAN ; MORTHIER, GEERT ; BAETS, ROEL.** Analysis and optimization of intensity noise reduction in spectrum-sliced WDM systems using a saturated semiconductor optical amplifier. *IEEE Photonics Technology Letters,* 2002, vol. 14 (3), 390-392
- **MORIMOTO, MASAHITO et al.** Co-propagating dual-order distributed Raman amplifier utilizing incoherent pumping. *IEEE Photonics Technology Letters,* 2017, vol. 29 (7), 567-570
- **MORIMOTO, MASAHITO et al.** Co-propagating distributed Raman amplifier utilizing incoherent pumping. *Metro and Data Center Optical Networks and Short-Reach Links II. International Society for Optics and Photonics,* 2019, 109460M
- **KOBAYASHI, TAKAYUKI et al.** 2nd-order forward-pumped distributed Raman amplification employing SOA-based incoherent light source in PDM-16QAM WDM transmission system. *IEICE Communications Express,* 2019
- PDM-16QAM WDM transmission with 2nd-order forward-pumped distributed Raman amplification utilizing incoherent pumping. **KOBAYASHI, TAKAYUKI et al.** Optical Fiber Communication Conference. Optical Society of America, 2019, Tu3F
- Broadband flat-noise Raman amplifier using low-noise bidirectionally pumping sources. **KADO, SOKO et al.** Proceedings 27th European Conference on Optical Communication. IEEE, 2001, 38-39
- **EMORI, YOSHIHIRO; ; KADO, SOKO ; NAMIKI, SHU.** Independent control of the gain and noise figure spectra of Raman amplifiers using bidirectional pumping. *Furukawa Review,* 2003, vol. 23, 11-15
- Fiber optic test and measurement/edited by Dennis Derickson. *Upper Saddle River,* 1998